# EUROPEAN PATENT SPECIFICATION

(11) **EP 1 659 641 B1**
(45) Date of publication and mention of the grant of the patent: **11.01.2012**
(21) Application number: 04425873.9
(22) Date of filing: 23.11.2004
(51) Int. Cl.: H01L 33/00

(54) **Process for manufacturing light emitting devices and device thereof**
Leuchtdiode und deren Herstellung
Diode luminescente et son procédé de fabrication

(43) Date of publication of application: 24.05.2006
(73) Proprietor: Centro Ricerche Plast-Optica S.p.A., 33020 Amaro (UD) (IT)
(72) Inventor: Sinesi, Sabino, C/o C.R.F. Società Consortile, 10043 Orbassano (Torino) (IT); Pairetti, Alberto, Via Jacopo Linussio 1 33020 Amaro (Udine (IT); Antonipieri, Michele, Via Jacopo Linussio 1 33020 Amaro (Udine (IT); Priante, Silvia, Via Jacopo Linussio 1 33020 Amaro (Udine (IT); Perlo, Piero, 12048 Sommariva Bosco (Cueno) (IT); Rotaris, Gianluca, Via Jacopo Linussio 1 33020 Amaro (Udine (IT)
(74) Representative: Freyria Fava, Cristina

(56) References cited:
- EP-A- 0 632 511
- EP-A- 1 162 668
- US-A1- 2002 185 651
- US-A1- 2002 185 965
- US-A1- 2002 187 570
- US-A1- 2003 089 914
- US-A1- 2004 036 081
- US-B1- 6 328 456
- US-B1- 6 617 786
- PATENT ABSTRACTS OF JAPAN vol. 1998, no. 08, 30 June 1998 (1998-06-30) & JP 10 065219 A (NIPPON RETSUKU KK), 6 March 1998 (1998-03-06)
- PATENT ABSTRACTS OF JAPAN vol. 016, no. 188 (E-1198), 7 May 1992 (1992-05-07) & JP 04 025185 A (OMRON CORP), 28 January 1992 (1992-01-28)

## Description

The present invention relates to a process for manufacturing light emitting devices, in particular comprising light emitting diodes (LED), of the type comprising the operations of:
- associating on a substrate one or more LED chips by a die-bonding operation,
- protecting the light emitting devices from external mechanical and environmental stresses by depositing an encapsulating material on the chips.

Obtaining light sources using devices such as light emitting diodes, also known as LEDs, is known.

US Patent Nr. 6,328,452 describes an LED with an encapsulation adapted to distribute radiated light energy over a wide viewing angle.

US Patent Application Publication US2002/0185651 describes an LED on a substrate with an encapsulation comprising a reflective coating that reflects vertically emitted light parallel to the plane of the substrate.

Said sources can use one or more LED or die chips (multi-layer semiconductor element which emits light radiation if powered) positioned directly on the printed circuit board; some possible applications are light signalling devices, head or tail lights for motor vehicles, public information devices, etc.

This technique is called COB (Chip On Board) technology and it usually provides for mounting LED chip matrices directly on the printed circuit board. This packaging technology comprises first the process known by the term "die-bonding" (thermal connection or electro-thermal connection), whereto are associated subsequent operations of "wire-bonding" (electrically connecting the LED to the circuit), and of "encapsulating" or protecting the source from external stresses.

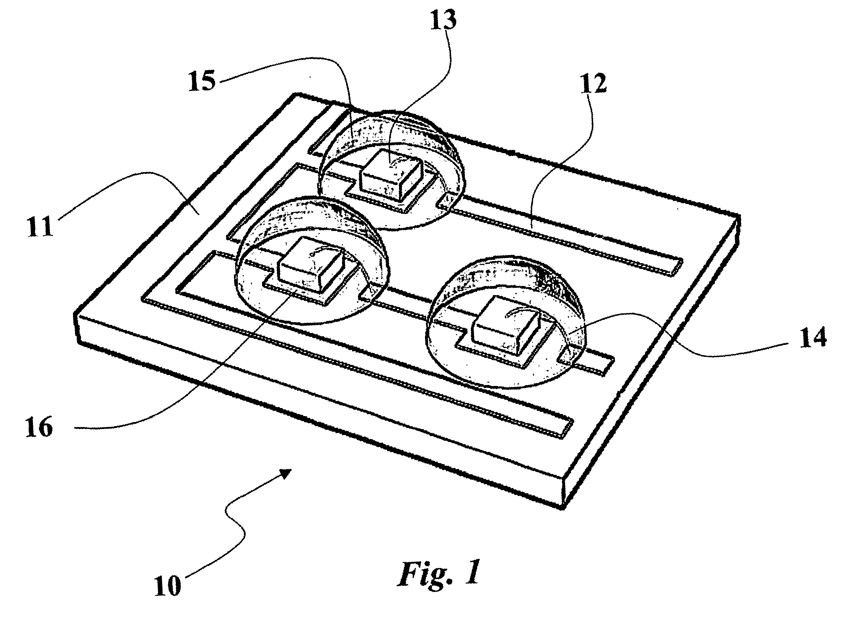

Figure 1 is a schematic and perspective view of a light source globally designated by the reference 10. Said light source 10 comprises a substrate 11, in particular a printed circuit, which bears conducting strips 12 whereon are bonded on appropriate conducting pads 16 by "die-bonding" some chips 13 to constitute the matrix of light emitting diodes (LED) 10. The reference 14 designates an electrical connection wire (wire-bonding operation) to obtain said matrix of LED sources.

As shown in Figure 1, each of the chips 13 is coated within the "packaging" operation by a so-called "glob-top" 15, i.e. a resinous encapsulation, substantially dome-shaped, which in addition to ensure the protection of the chip 13 from any external stresses also serves optical functions.

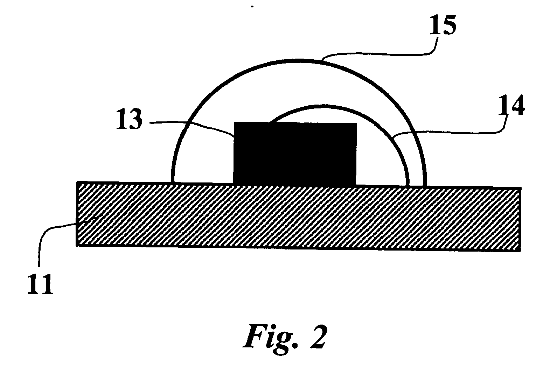

Figure 2 shows a lateral section of one of the chips 13, where the substantially spherical shape of the resinous encapsulation constituting the glob-top 15 is readily apparent.

Due to the great difference in refraction index between the materials that constitute the light source, usually silicon or semiconductor material, and the surrounding environment, which is usually air, most of the light flow emitted by the active layer of the light source remains trapped in the chip itself by total internal reflection. To increase extraction efficiency, as seen in relation to Figures 1 and 2, the chip is coated with material having high refraction index, i.e. the aforesaid glob-top. Said materials, in addition to increasing, as stated above, the efficiency of extracting light from the light emitting diodes, also have the aim of protecting the source from humidity and from mechanical stresses.

Typically, the radiation emitted by the chip is controlled through an external lens obtained by casting around the chip protected by the glob-top, which usually serves only the protection function.

Thus, known systems suffer from a poor optical coupling of the glob-top with the external lens.

The object of the present invention is to solve this problem in a simple and effective way.

In order to achieve this object, the object of the invention is a process for manufacturing light emitting devices having the characteristics set out in the annexed claim 1. The invention further relates to a light emitting device manufactured according to said process. Preferred embodiments of said process are set out in the subsequent dependent claims.

The invention will now be described, by way of example only, with reference to the enclosed figures of drawing, wherein:
- Figure 1 is a schematic perspective view of an example of a light source whereto the process according to the invention is applicable;
- Figure 2 shows a detail of the light source of Figure 1;
- Figure 3 shows a first set of operations of the process that does not form part of the invention;
- Figure 4 shows a second set of operations of the method according to the invention;
- Figure 5 shows a device produced with the process of Figure 4;
- Figure 6 shows a third set of operations of the process according to the invention; and
- Figure 7 shows a fourth set of operations of the process according to the invention;
- Figure 8 shows a possible configuration of optical coupling between light source with shaped glob-top and optics of the final device.

The idea constituting the basis of the process according to the invention substantially comprises the conformation operation of the encapsulation, or glob-top, to optically couple the electromagnetic radiation emitted by the light emitting devices (LED) in the form of chip, or die, with the external lens. The glob-top is shaped in such a way that the light rays, exiting the glob-top and then meeting a medium with different refraction index, for example air, are deflected according to the optical laws and meet the external lens in the desired manner.

The conformation is obtained by dispensing a controlled volume of resin into moulds and/or masks and exploiting the surface tension of the resin that constitutes the glob-top.

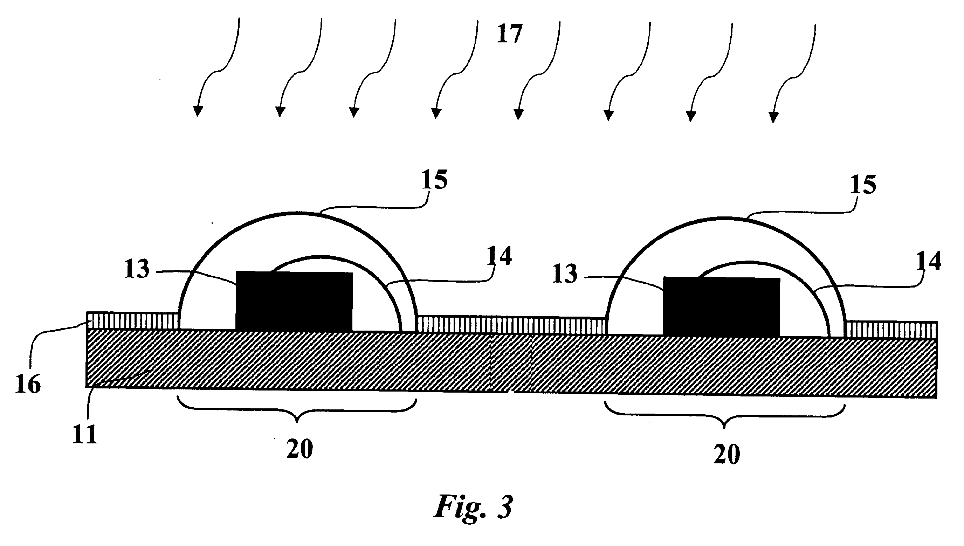

Figure 3 shows a first conformation procedure of a glob-top 15 that does not form part of the invention. On the substrate 11 is applied a removable holed mask 16 which comprises openings 20 centred on the chips 13. The height of the removable holed mask 16 and the viscosity of the material allow to confine the resin used to obtain the glob-top 15 within the openings 20. Once the resin forming the glob-top 15 was cast and confined by the removable holed mask 16, it is irradiated by means of an ultraviolet radiation 17 to obtain the reticulation and hence the hardening of the glob-top 15. This first conformation operation thus allows correctly to align the glob-top 15 with the external lens, not shown in the Figure. In this case, the glob-top 15 assumes a spherical shape by virtue of the confinement of the openings 20, which have circular shape.

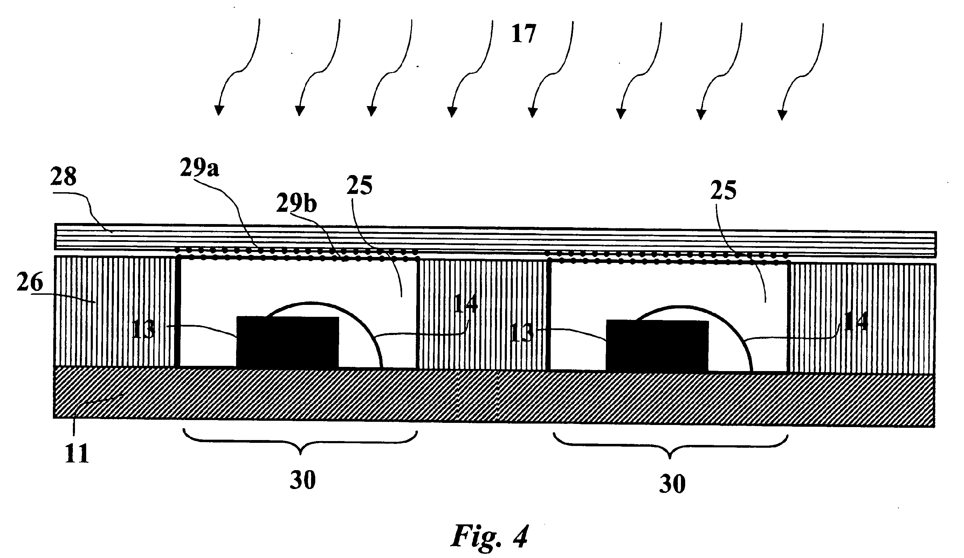

Figure 4 shows a second conformation procedure of a glob-top 25. On the substrate 11 is applied a removable holed mask 26 having openings 30 with walls whose height exceeds the chips 13, so it embodies a mould around said chips 13. Into said cylindrically shaped mould is then cast the resin to form the glob-top 25. Subsequently, on the removable holed mask 26 is applied a forming mask 28 which bears, on its lower part in contact with the removable holed mask 26 at the openings 30 that define the glob-top 25, micro-etchings 29a able to define micro-optics 29b on the upper part of the glob-top 25 by moulding. Said micro-optics 29b have the purpose of constituting optical micro-elements on the surface of the glob-top 25 which improve the optical coupling with the outer lens. In this case too, the procedure is completed irradiating the glob-top 25 thereby obtained with ultraviolet radiation 17 in order to obtain the reticulation of the resin and hence the hardening of the glob-top 25.

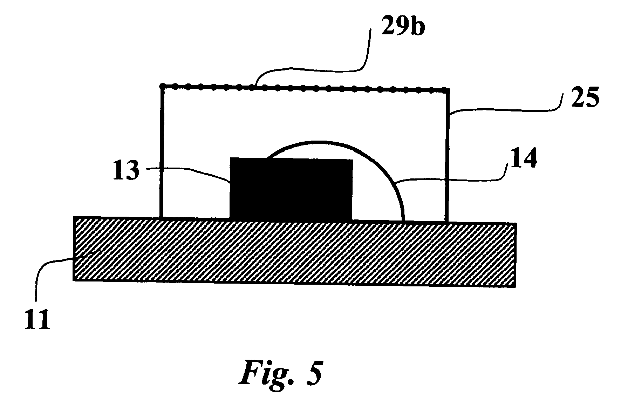

Figure 5 shows a lateral section of one of the chip 13 which clearly illustrates the substantially cylindrical shape of the glob-top 25 obtained by means of the _second procedure described with reference to Figure 4.

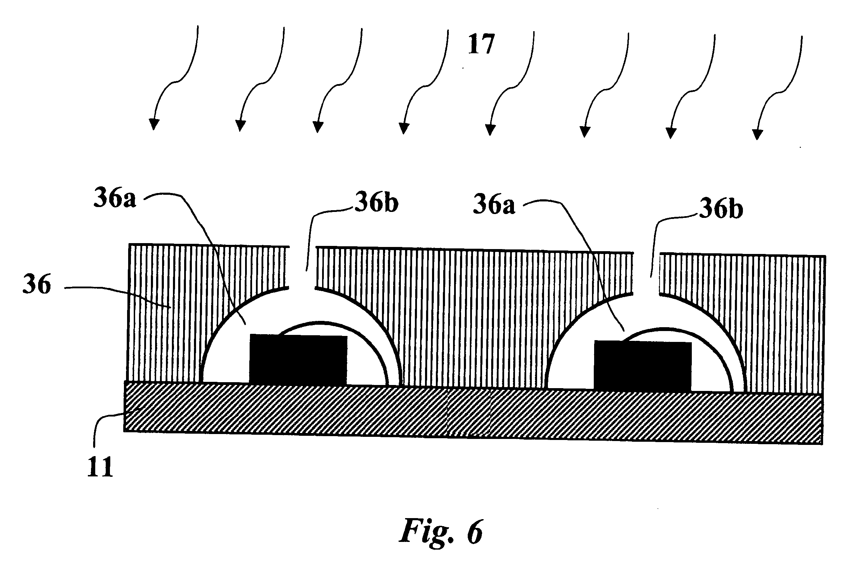

Figure 6 shows a third conformation procedure of a glob-top. In this case, the holed mask 36 is constituted by a single removable element of appropriate shape, which may bear micro-etchings able to define micro-optics. This third procedure provides for applying on the substrate 11 a removable mask having chambers 36, such a mask thus comprising chambers 36a into which access is possible by means of through vertical channels 36b. The resin destined to form the glob-top 15 is cast through said channels 36b and it fills said chambers 36a. Subsequently, the ultraviolet radiation 17 is applied to obtain the reticulation of the resin and hence the hardening of the glob-top 15. In a preferred version the removable mask with chambers 36 is transparent to ultraviolet radiation 17 so it need not be removed to obtain the hardening of the resin. Clearly, the masks 26 and 28 of Figure 4 can also be similarly made of a material that is transparent to ultraviolet radiation 17.

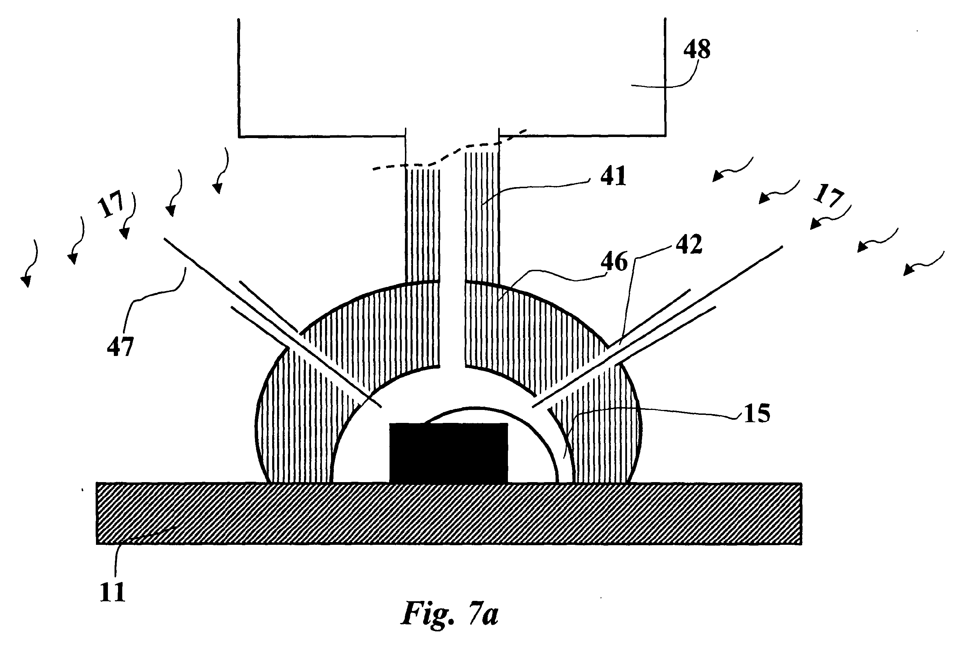

Figure 7a shows a fourth conformation procedure of a glob-top 15. On the substrate 11 is applied a micro-mould 46, connected to a dispensing syringe 48, which comprises a through channel 41, into which is cast the resin used to obtain the glob-top 15.

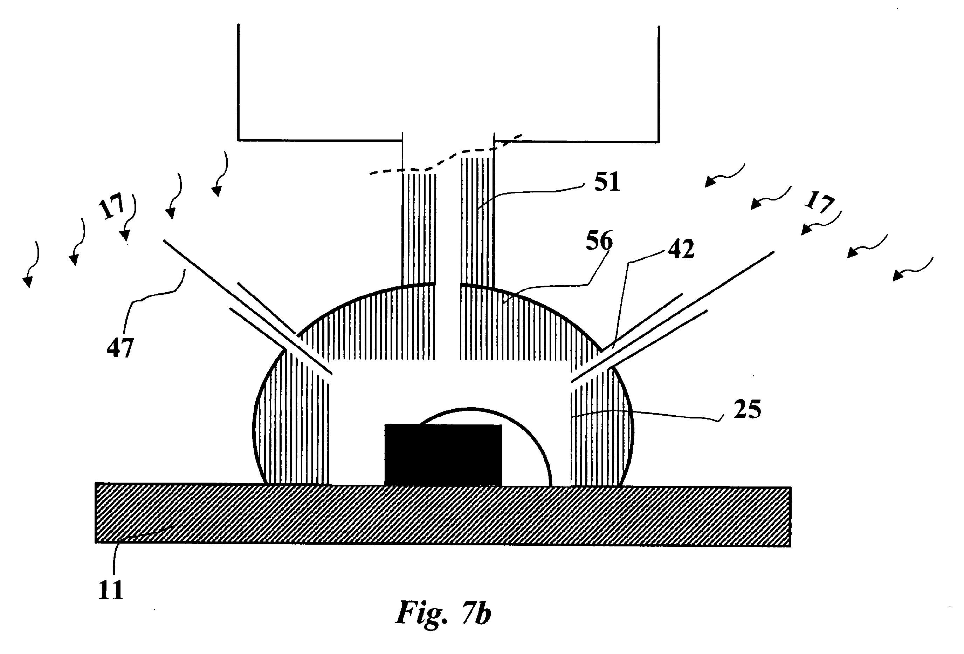

Figure 7b shows a micro-mould 56 whose shape and volume are suitable to obtain different shapes of glob-top 25. The inner walls of the micro-mould 56 can be smooth or bear, similarly to what is described in relation to Figure 4, of the micro-etchings able to define by moulding micro-optics on the walls of the glob-top. The resin that forms the glob-top 15 is cast through the through vertical central channel 51 and fills the micro-mould 56. In this case, too, the procedure is completed by irradiating the glob-top 25 thereby obtained with the ultraviolet radiation 17 to obtain the reticulation of the resin and hence the hardening of the glob-top 25. In the embodiment shown in Figure 7a, the micro-mould 46 is opaque to ultraviolet radiation 17 and it comprises lateral channel 42 used to apply the ultraviolet radiation 17 to the resin. In these cases, the hardening of the resin is obtained by applying the ultraviolet radiation 17 through optical fibres 47 associated to the lateral channels 42. Alternately, the micro-mould 46 can be transparent to ultraviolet radiation 17.

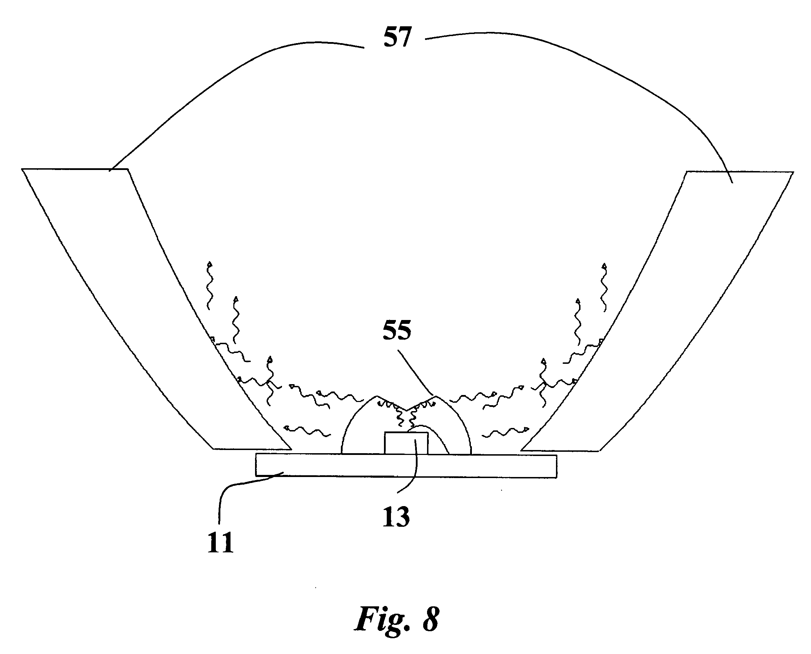

A simple example of possible conformation of the glob-top to improve optical coupling is shown in Figure 8, and it pertains to the case in which a particularly compact optical system is to be obtained by coupling a TIR (Total Internal Reflection) or a metallised mirror with a source, characterised by a strong lateral emission (i.e., parallel to the plane of lay of the source itself). Since most of the light radiation is emitted under very small angles relative to the plane of lay, the depth of the mirror can be limited without losing efficiency. To obtain this effect, it is possible to shape a resin glob-top 55, in such a way as to reflect upwardly directed light in a direction that is parallel to the plane of the substrate by total internal reflection towards a mirror 57, which in this case serves as an element to control the radiation emitted by the chip, instead of the lens. Naturally the mirror 57 can also be coupled to one or more lenses, or to other optical devices suitable to serve said function of controlling the radiation emitted by the chip 13.

From the above description, the advantages of the proposed process are readily apparent.

Advantageously, the process according to the invention provides conformation operations of the glob-top, or encapsulation, so it is possible to give to said encapsulation the most suitable shape to achieve the best optical coupling with the lens or more in general with the external optical system. This shape can have a spherical or cylindrical symmetry, although clearly the techniques described herein can also be applied to obtain different shapes. The optical coupling can advantageously be improved by means of the simultaneous moulding of micro-optics such as reflector elements or lenses.

Advantageously, the process according to the invention also allows to dispense a controlled volume of resin into the openings of the masks of the moulds, allowing to obtain a greater uniformity of shape and/or volume for the encapsulations.

The adoption of micro-moulds allows to perform the process or reticulation of the resin with ultraviolet rays on site.

Naturally, without altering the principle of the invention, the construction details and the embodiments may vary widely from what is described and illustrated purely by way of example herein, without thereby departing from the scope of the present invention.

Each of the masks and micro-moulds described above may be transparent or opaque to the ultraviolet light used for resin reticulation. The reticulation may also be obtained by a thermal process.

Micro-structuring for the purpose of modulating and modifying the optical properties may be applied, in addition to the masks and to the moulds, also to the metal pads inside the glob-top whereon the moulds are fastened, in order to control the reflected light.

The device obtained with the process of the invention is preferably applied to head and tail lights for motor vehicles, but it can clearly be applied in any field wherein light emitting devices are used constituted by one or more chips and protected from stresses by depositing an encapsulation.

Removable masks can be made of different materials, e.g. metal (exploiting the magnetic properties of certain metals, it is possible to use a system of magnets for engaging/disengaging the masks), organic material (which can be removed by dissolution in appropriate solvent), glass or quartz (thus allowing ultraviolet irradiation from all directions).

Naturally, the materials used for the masks may vary widely from what is described purely by way of example herein, without thereby departing from the scope of the present invention.

## Claims

1. A process for manufacturing light emitting devices (LED) of the type comprising the operations of:
- associating one or more LED chips (13) on a substrate (11) by a die-bonding operation,
- protecting said light emitting chips (13) from stresses by depositing an encapsulation (15; 25; 55) on said chips (13),
said process further comprising a conformation operation of said encapsulation (15; 25; 55) to optically couple an electromagnetic radiation emitted with an external optical element (57) for controlling the radiation emitted by the chip (13),
said conformation operation is conducted in such a way as to take into account the optical coupling between said encapsulation (15; 25; 55) and said optical element (57) for controlling the radiation emitted by the chip (13) mediated through a different medium, in particular air, said conformation operation including shaping said encapsulation (55), in such a way as to reflect upwardly directed light by total internal reflection towards said optical element (57) for controlling the radiation emitted by the chip (13), said upwardly directed light being reflected by total internal reflection in a direction that is parallel to the plane of the substrate.

2. The process of claim 1, wherein
said conformation operation of said encapsulation (15; 25; 55) comprises positioning confinement masks (16; 26; 36) provided with through openings (20; 30; 36) which allow the deposition of said encapsulation (15; 25; 55).

3. The process of claim 2, wherein
said through openings (30) have walls whose height exceeds that of the chips (13).

4. The process of claim 1, wherein
said conformation operation of said encapsulation (15; 25; 55) comprises applying removable forming masks (28) on said encapsulation (15; 25; 55).

5. The process of claim 4, wherein
said forming masks (28) have micro-etchings (29a) to obtain micro-optics (29b) on said encapsulation (15; 25; 55).

6. The process of claim 2 or 3 and claim 4 or 5,
wherein said operation of applying forming masks (28) is performed after the operation of positioning confinement masks (16; 26) provided with through openings (20; 30).

7. The process of claim 1, wherein
said conformation operation of said encapsulation (15; 25; 55) comprises using of masks having chambers (36) on said chips (13) and depositing said encapsulation (15; 25; 55) in said chambers (36a) by means of through channels (36b).

8. The process of claim 1, wherein
said conformation operation comprises the use of micro-moulds (46; 56).

9. The process of claim 8, wherein
said micro-moulds (46, 56) have inner walls with micro-etchings (29a) to obtain micro-optics (29b) on said encapsulation (15; 25; 55).

10. The process of one or more of the claims from 2 to 9, further comprising a step of reticulating the encapsulation (15; 25; 55) by the application of an ultraviolet radiation (17) and said removable confinement masks (16; 26) and/or said forming masks (28) and/or said masks with chambers (36) and/or said micro-moulds (46; 56) are made of material that is transparent to an ultraviolet radiation (17).

11. The process of one or more of the claims from 1 to 10, further comprising the operation of electrically connecting said chips (13) to control circuits on said substrate (11).

12. The process of one or more of the claims from 1 to 11, wherein said optical element (57) for controlling the radiation emitted by the chip (13) comprises a lens or mirror.

13. Light emitting device constituted by one or more solid state sources, obtained positioning chips (13) on a substrate (11), including an encapsulation (15; 25; 55) for protecting from stresses which covers said chip (13), **characterised in that** said encapsulation (15; 25; 55) is formed with the conformation operation according to one or more of the claims from 1 to 11.

14. The light emitting device of claim 13,
inserted in a tail light and/or headlight of a motor vehicle.

15. The light emitting device of claim 13, inserted in a luminous device for public information.

## Patentansprüche

1. Verfahren zur Herstellung von Licht emittierenden Vorrichtungen (LED) des Typs, welcher die Vorgänge enthält:
- Verbinden eines oder mehrerer LED-Chips (13) auf einem Substrat (11) durch einen Die-Bonding-Vorgang,
- Schützen der Licht emittierenden Chips (13) gegen Belastungen durch Abscheiden einer Verkapselung (15; 25; 55) auf den Chips (13),
welches Verfahren ferner einen Vorgang zum Aufbau der Verkapselung (15; 25; 55) enthält, um eine emittierte elektromagnetische Strahlung mit einem externen optischen Element (57) optisch zu koppeln, um die von dem Chip (13) emittierte Strahlung zu steuern,
wobei der Aufbauvorgang dergestalt durchgeführt wird, dass die optische Kopplung zwischen der Verkapselung (15; 25; 55) und dem optischen Element (57) zur Steuerung der von dem Chip (13) emittierten Strahlung, die durch ein unterschiedliches Medium, insbesondere Luft, vermittelt wird, berücksichtigt wird, wobei der Aufbauvorgang das Formen der Verkapselung (55) in einer Weise einschließt, dass nach oben gerichtetes Licht durch vollständige interne Reflexion zu dem optischen Element (57) zur Steuerung der von dem Chip (13) emittierten Strahlung reflektiert wird, wobei das nach oben gerichtete Licht durch vollständige interne Reflexion in einer Richtung reflektiert wird, die parallel zu der Substratebene ist.

2. Verfahren nach Anspruch 1, bei welchem der Aufbauvorgang der Verkapselung (15; 25; 55) das Positionieren von Begrenzungsmasken (16; 26; 36) enthält, welche mit Durchgangsöffnungen (20; 30; 36) versehen sind, welche das Abscheiden der Verkapselung (15; 25; 55) erlauben.

3. Verfahren nach Anspruch 2, bei welchem die Durchgangsöffnungen (30) Wände haben, deren Höhe die der Chips (13) übersteigt.

4. Verfahren nach Anspruch 1, bei welchem der Aufbauvorgang der Verkapselung (15; 25; 55) das Aufbringen von entfernbaren Formmasken (28) auf die Verkapselung (15; 25; 55) enthält.

5. Verfahren nach Anspruch 4, bei welchem die Formmasken (28) Micro-Ätzungen (29a) aufweisen, um Micro-Optiken (29b) auf der Verkapselung (15; 25; 55) zu erhalten.

6. Verfahren nach Anspruch 2 oder 3 und Anspruch 4 oder 5, bei welchem der Vorgang des Aufbringens von Formmasken (28) nach dem Vorgang der Positionierung von mit Durchgangsöffnungen (20; 30) versehenen Begrenzungsmasken (16; 26) durchgeführt wird.

7. Verfahren nach Anspruch 1, bei welchem der Aufbauvorgang der Verkapselung (15; 25; 55) die Verwendung von Masken mit Kammern (36) auf den Chips (13) und das Abscheiden der Verkapselung (15; 25; 55) in den Kammern (36a) mittels Durchgangskanälen (36b) enthält.

8. Verfahren nach Anspruch 1, bei welchem der Aufbauvorgang die Verwendung von Micro-Formen (46; 56) enthält.

9. Verfahren nach Anspruch 8, bei welchem die Micro-Formen (46, 56) Innenwände mit Micro-Ätzungen (29a) haben, um Micro-Optiken (29b) auf der Verkapselung (15; 25; 55) zu erhalten.

10. Verfahren nach einem oder mehreren der Ansprüche 2 bis 9, ferner enthaltend einen Schritt der Vernetzung der Verkapselung (15; 25; 55) durch Anwendung von Ultraviolettstrahlung (17), wobei die entfernbaren Begrenzungsmasken (16; 26) und/oder die Formmasken (28) und/oder die Masken mit Kammern (36) und/oder die Micro-Formen (46; 56) aus Material hergestellt sind, dass für Ultraviolettstrahlung (17) durchlässig ist.

11. Verfahren nach einem oder mehreren der Ansprüche 1 bis 10, ferner enthaltend den Vorgang des elektrischen Verbindens der Chips (13) mit Steuerschaltungen auf dem Substrat (11).

12. Verfahren nach einem oder mehreren der Ansprüche 1 bis 11, bei welchem das optische Element (57) zur Steuerung der von dem Chip (13) emittierten Strahlung eine Linse oder einen Spiegel aufweist.

13. Licht emittierende Vorrichtung, gebildet durch eine oder mehrere Festkörper-Quellen, erhalten durch Positionieren von Chips (13) auf einem Substrat (11), umfasseend eine Verkapselung (15; 25; 55) zum Schutz vor Belastungen, welche den Chip (13) bedeckt, **dadurch gekennzeichnet, dass** die Verkapselung (15; 25; 55) mit dem Aufbauvorgang gemäß einem oder mehreren der Ansprüche 1 bis 11 gebildet wird.

14. Licht emittierende Vorrichtung nach Anspruch 13, eingesetzt in ein Rücklicht und/oder einen Scheinwerfer eines Kraftfahrzeugs.

15. Licht emittierende Vorrichtung nach Anspruch 13, eingesetzt in eine Leuchtvorrichtung für öffentliche Informationen.

## Revendications

1. Procédé pour la fabrication de dispositifs électroluminescents (LED) du type comprenant les opérations de:
- association d'une ou plusieurs puces de LED (13) sur un substrat (11) par une opération de soudage sur substrat,
- protection desdites puces électroluminescentes (13) contre les contraintes par dépôt d'une encapsulation (15; 25; 55) sur lesdites puces (13),
ledit procédé comprenant en outre une opération de conformation de ladite encapsulation (15; 25; 55) pour coupler optiquement un rayonnement électromagnétique émis avec un élément optique externe (57) pour régler le rayonnement émis par la puce (13),
ladite opération de conformation est conduite de manière à prendre en compte le couplage optique entre ladite encapsulation (15; 25; 55) et ledit élément optique (57) pour régler le rayonnement émis par la puce (13) passant à travers un milieu différent, en particulier l'air, ladite opération de conformation comprenant la mise en forme de ladite encapsulation (55), de manière à refléter la lumière dirigée vers le haut par réflexion interne totale en direction dudit élément optique (57) pour régler le rayonnement émis par la puce (13), ladite lumière dirigée vers le haut étant réfléchie par réflexion interne totale dans une direction qui est parallèle au plan du substrat.

2. Procédé selon la revendication 1, dans lequel ladite opération de conformation de ladite encapsulation (15; 25; 55) comprend des masques de confinement de positionnement (16; 26; 36) munis d'ouvertures traversantes (20; 30; 36) qui permettent le dépôt de ladite encapsulation (15; 25; 55).

3. Procédé selon la revendication 2, dans lequel lesdites ouvertures traversantes (30) ont des parois dont la hauteur dépasse celle des puces (13).

4. Procédé selon la revendication 1, dans lequel ladite opération de conformation de ladite encapsulation (15; 25; 55) comprend l'application de masques de façonnage amovibles (28) sur ladite encapsulation (15; 25; 55).

5. Procédé selon la revendication 4, dans lequel lesdits masques de façonnage (28) ont des micro-gravures (29a) pour l'obtention de micro-optiques (29b) sur ladite encapsulation (15; 25; 55).

6. Procédé selon la revendication 2 ou 3 et la revendication 4 ou 5, dans lequel ladite opération d'application de masques de façonnage (28) est effectuée après l'opération de positionnement de masques de confinement (16; 26) munis d'ouvertures traversantes (20; 30).

7. Procédé selon la revendication 1, dans lequel ladite opération de conformation de ladite encapsulation (15; 25; 55) comprend l'utilisation de masques ayant des chambres (36) sur lesdites puces (13) et le dépôt de ladite encapsulation (15; 25; 55) sur lesdites chambres (36a) au moyen de canaux traversants (36b).

8. Procédé selon la revendication 1, dans lequel ladite opération de conformation comprend l'utilisation de micro-moules (46; 56).

9. Procédé selon la revendication 8, dans lequel lesdits micro-moules (46; 56) ont des parois internes ayant des micro-gravures (29a) pour l'obtention de micro-optiques (29b) sur ladite encapsulation (15; 25; 55).

10. Procédé selon l'une ou plusieurs des revendications 2 à 9, comprenant en outre une étape de réticulation de l'encapsulation (15; 25; 55) par l'application d'un rayonnement ultraviolet (17), et lesdits masques de confinement amovibles (16; 26) et/ou lesdits masques de façonnage (28) et/ou lesdits masques avec des chambres (36) et/ou des micro-moules (46; 56) sont constitués en matériau qui est transparent à un rayonnement ultraviolet (17).

11. Procédé selon l'une ou plusieurs des revendications 1 à 10, comprenant en outre l'opération de connexion électrique desdites puces (13) à des circuits de réglage sur ledit substrat (11).

12. Procédé selon l'une ou plusieurs des revendications 1 à 11, dans lequel ledit élément optique (57) pour régler le rayonnement émis par la puce (13) comprend une lentille ou un miroir.

13. Dispositif électroluminescent constitué par une ou plusieurs sources à l'état solide, obtenu par positionnement de puces (13) sur un substrat (11), comprenant une encapsulation (15; 25; 55) de protection contre les contraintes qui recouvre ladite puce (13), **caractérisé en ce que** ladite encapsulation (15; 25; 55) est formée avec l'opération de conformation conformément à une ou plusieurs des revendications 1 à 11.

14. Dispositif électroluminescent selon la revendication 13, inséré dans un feu arrière et/ou un feu avant d'un véhicule automobile.

15. Dispositif électroluminescent selon la revendication 13, inséré dans un dispositif lumineux pour l'information du public.
